## Europäisches Patentamt

## European Patent Office

## Office européen des brevets

(11) Publication number: **0 101 941**
**B1**

# EUROPEAN PATENT SPECIFICATION

(45) Date of publication of patent specification: **31.05.89**

(51) Int. Cl.⁴: **H 01 P 1/22**

(21) Application number: **83107415.8**

(22) Date of filing: **27.07.83**

(54) High speed high power step attenuator method and apparatus.

(30) Priority: **28.07.82 US 402622**

(43) Date of publication of application:
**07.03.84 Bulletin 84/10**

(45) Publication of the grant of the patent:
**31.05.89 Bulletin 89/22**

(84) Designated Contracting States:
**AT CH DE FR GB IT LI NL SE**

(56) References cited:
**FR-A-1 156 362**
**US-A-3 323 080**
**US-A-3 381 244**
**US-A-3 769 610**
**US-A-4 016 516**
**US-A-4 216 445**
**US-A-4 267 538**
**ELECTRONIC ENGINEERING, vol. 48, no.581,
July 1976, pages 41-45, London, GB; J.
HELSZAJN: "Control circuits for microwave
applications using p-i-n diodes"**

(73) Proprietor: **TEXTRON INC.**
**40 Westminster Street**
**Providence, Rhode Island 02903 (US)**

(72) Inventor: **Pon, Chuck Y.**
**1915 Chula Vista**
**Belmont California (US)**

(74) Representative: **Bernhardt, Klaus, Dipl.-Ing.**
**Radeckestrasse 43**
**D-8000 München 60 (DE)**

(56) References cited:
**IEEE TRANSACTIONS ON MICROWAVE
THEORY AND TECHNIQUES, vol. MTT-27, no.
1, January 1979, pages 89-90, IEEE, New York,
US; L. NYSTRÖM: "A new microwave variable
power divider"**

**5th EUROPEAN MICROWAVE CONFERENCE,
1st-4th September 1975, Hamburg, DE,pages
128-132, Microwave Exhibitions and Publishers
Ltd., Sevenoaks, Kent, GB; S. REHNMARK:
"Wideband planar transmission line PIN-diode
attenuator/modulator"**

Courier Press, Leamington Spa, England.

(56) References cited:
**PATENTS ABSTRACTS OF JAPAN, vol. 6, no.
128 (E-118)1006r, 14th July 1982; & JP - A - 57
54 402 (NIPPON DENKI K.K.) 31-03-1982**

## Description

Technical field

Generally the present invention is directed to attenuation of electromagnetic signals, and particularly to a high speed step attenuator and attenuation method for high frequency, high power signals.

Background art

In "Electronic Engineering", Volume 48, No. 581, July 1976, pages 41 to 45, there is disclosed an apparatus for attenuating a high frequency electromagnetic input signal having a predetermined power magnitude comprising means responsive to the input signal for splitting the input signal into a first signal and a second signal, each having a predetermined magnitude the sum of which is substantially equal to the input signal magnitude, the input signal splitting means having a first output port for outputting the first signal, and a second output port for outputting the second signal, the input port being isolated from the first and second output ports in that waveforms reflected from the first and second output ports and back into the input signal splitting means cancel one another at the input port and are additive with one another at a termination port for dissipation there; mismatch means in communication with the first and second output ports for providing an adjustable impedance mismatch at each output port so that a portion of the first signal from the first output port and a portion of the second signal from the second output port are reflected back into the input signal splitting means for dissipation in a termination, and so that the unreflected portion of each of the first and second signals are transmitted, said mismatch means comprising; a first length of stripline transmission line electrically connecting the first output port to a recombination means; a second length of strip line transmission line electrically connecting the second output port to the recombination means and mismatch means for controlling the degree of impedance mismatch, said mismatch comprising first and second resistance means which produce said degree of impedance mismatch and which are arranged in parallel with the first and second lengths of transmission line respectively, as well as a method for the attenuation of a high frequency, high power electromagnetic input signal comprising the following steps:

splitting the input signal into a first split signal and a second split signal by way of a first coupler means wherein the first split signal is shifted in phase from the second split signal by a predetermined amount and both split signals have substantially equal power magnitudes, the total of which substantially equals the input signal power magnitude; applying the first and second split signals to a variable impedance mismatch so that a portion of the first and second split signals is reflected and a portion is transmitted to a second coupler means, the first coupler means then dissipating the reflected signal portions internally; and recombining the transmitted portion of the split signal in a second coupler means by phase shifting one of the split signals to be substantially equal in phase to the other split signal and by adding the resulting signals together, said variable impedance mismatch being selected so that the sum of the power magnitudes of the transmitted portions of the split signals corresponds to the input signal power magnitude which has been attenuated by a desired amount.

In this prior art apparatus and method, PIN diodes are biased by the application of direct current, the level of which is continuously adjustable, in order to make the PIN diodes appear to have a particular resistance. Thus the PIN diodes are used as variable resistors to provide variable levels of mismatch.

A slightly different approach is used in "IEEE Transactions on Microwave Theory and Techniques" vol. MTT-27, No. 1, January 1979, pages 89 to 90 in that instead of PIN diodes, varactor diodes are biased to provide different capacitances connected in shunt along transmission lines between hybride couplers.

PIN diodes used as variable resistors, or varactor diodes used as variable capacitors are sensitive to temperature and power variations and thus make it necessary to carefully control these parameters which control means inherently resist fast acting signals.

There has been a long felt need in the microwave frequency art for a step attenuator which is capable of providing attenuation of high power microwave frequencies, in selectable steps, which is switchable between steps at a very high speed.

In the past, there have been several proposed step attenuators, as discussed in a publication entitled "Get Back to Basics with Step Attenuator Design" by Fulvio Ananasso, in Microwaves, February 1979, pages 76 through 81.

One of the attenuators discussed in the article invovles the use of a pin diode which is employed as a variable resistance element. The pin diode is connected in shunt across a transmission line. A DC biasing voltage is applied to the pin diode in order to select a specific attenuating resistance value. When the pin diode is disconnected from the circuit, by reverse biasing the diode, a capacitance is required in series with the diode in order to resonate the intrinsic inductance and reverse capacitance of the diode out of the circuit. Among the drawbacks of such a configuration is the requirement that 1) the biasing voltage be precise and be compensated over temperature for consistent attenuation characteristics; 2) generation of reflected waveforms back to the input signal source by the mismatch introduced into the circuit by the non-characteristic resistance of the pin diode; and 3) the narrow bandwidth of such a circuit due to the requirement that the intrinsic inductance of the pin diode be resonated out of the circuit.

Another embodiment of attenuator is discussed in the above identified article, one which employs selectable parallel signal paths, one path having no attenuation therein and the other signal path having a matched, resistive attenuation. The switching between signal paths is obtained by appropriately biasing pin diodes into a conducting or non-conducting state. In order to obtain attenuation in steps, several of these parallel signal path circuits could be connected in series, with each of the circuits providing a different degree of resistive attenuation, so that by selecting combinations of the various attenuation factors, the desired total attenuation can be obtained.

One of the drawbacks of such a configuration is the high component count required. For example, at least two pin diodes are required for each signal path, with it being recommended that several pin diodes be used in place of a single pin diode, in order to provide adequate isolation. Additionally, it is recommended that pi or tee networks be used for the resistive attenuation elements. This is based upon the need to avoid any impedance mismatches in the circuit to prevent reflected waves from being returned to the input of the attenuator. These tee or pi networks require a minimum of three resistive components to implement.

A further drawback of this second configuration is that the pin diodes are used as switches therein and are therefore subjected to high power levels. This can lead to component failure, or a shortened component life. The connection of the pin diodes in series with the signal paths renders heat sinking of the diodes difficult, thereby further complicating thermal requirements, such as the maintaining the temperature of the diode junction below a maximum temperature.

A drawback which is common to both of the above discussed attenuator configurations is the speed by which the pin diodes can be switched off and on or from one bias point to another. In the above configurations, the switching time of the pin diodes is often less than satisfactory. This is due, especially in the second configuration, to the high operating signal levels of the various pin diodes. In such a high power operating mode, the intrinsic capacitance of the diode is substantial and as such, there is a bothersome response time between the application of the command to switch between states and the actual switching of the pin diodes between states.

Thus there is a long-felt need for a high frequency, high speed, high power step attenuator in which the component count is reduced, the operating stress upon the components decrease, and the switching time between steps decreased.

Disclosure of invention

Accordingly, it is the object of the present invention to provide an apparatus and method of the type indicated above which allows high switching speeds at short intervals.

To achieve this objective, an apparatus of the above indicated type is modified according to the invention in that said first and second resistance means are fixed resistance means which are selectably connectable in parallel with the respective length of transmission line; and connection means are provided for said selectably connecting of the first and second fixed resistance means to the first and second lengths of transmission line; while the method of the above indicated type is modified in accordance with the invention, to achieve the stated goal, in that for attenuating said input signal in selectable steps said first and second split signals are applied to a selectable impedance mismatch comprising fixed resistive means.

By using fixed resistance means and switching them in and out of parallel connection with the transmission lines, any delays are eliminated which are necessarily associated with the adjustment of variable bias currents or voltages, in particular delays necessitated by closely monitoring temperature and power variations, and so the disadvantages of the prior art apparatus and method relating to continuously adjustable mismatch means are avoided. Further, in the present invention the switches are operating at a lower signal magnitude than the comparable switches in the above discussed prior art step attenuators, due to the splitting of the input signal between two signals paths. As a result of this lower operating magnitude, switches having a lower power rating and attendant higher inherent switching speed can be selected; this is in particular true because the series connection of the switch with some resistive element further reduces the power handling requirements for the switch.

Switching resistive elements in parallel with the signal paths of the attenuator ensures that the value of the mismatch, or attenuation, obtained can be controlled precisely by controlling the precision of the resistive elements used.

In another embodiment of the invention the first and second fixed resistance means each comprise a chip resistor having a predetermined resistance, and the selective connecting means comprise a chip resistor having a predetermined resistance, and further the selective connecting means comprise a first pin diode connected in series with the first chip resistor; a second pin diode connected in series with the second chip resistor; and biasing means for selectively reverse biasing the first and second pin diodes to rapidly disconnect the first and second resistance means from the first and second lengths of transmission line, and for selectively forward biasing the first and second pin diodes to rapidly connect the first and second resistance means to the first and second lengths of transmission line.

Preferably, the recombining means comprises a quadrature coupler having a first input port responsive to the first signal, a second input port responsive to the second signal, an output port, and a termination port, while the first input port is electrically connected to the output port and electromagnetic coupled to the termination port, and further the second input port is electromatically coupled to the output port and electrically connected to the termination port, so that the first and second signals are combined within the recombining means for output from the output port.

The first fixed resistance means may include, and in the same way the second fixed resistance means may include each a plurality of lumped resistance elements each of which is selectably connectable in shunt with the respective length of transmission line; each of the first plurality of lumped resistance elements having substantially the same values of resistance as corresponding ones of the second plurality of lumped resistance elements so that by selecting corresponding resistance elements from the first and second plurality of resistance elements an impedance mismatch having a selectable magnitude can be created.

In the preferred embodiment having PIN diodes connected in series with the chip resistors, the· biasing means preferably comprise a first driver means for driving the first pin diode and a second driver means for driving the second pin diode; each driver means providing an initial high current spike and a subsequent steady state biasing voltage so that the pin diodes can be switched between off and on states with a minimum of delay.

Further details of the invention are given in the following detailed description of certain preferred embodiments of the invention, taken in conjunction with the accompanying drawings.

Brief description of drawings

Figure 1 is a schematic of a prior art attenuator.

Figure 2 is a simplified schematic of another prior art step attenuator.

Figure 3 is a simplified functional block diagram of the present invention.

Figure 4 is a simplified schematic of one embodiment of the present invention.

Figure 5 is a top view of a simplified physical layout of one embodiment of the present invention.

Figure 5A is an expanded view of one section of the physical layout of Figure 5.

Figure 5B is a side view of Figure 5 taken along lines 5B—5B, including ground planes.

Best mode for carrying out the invention

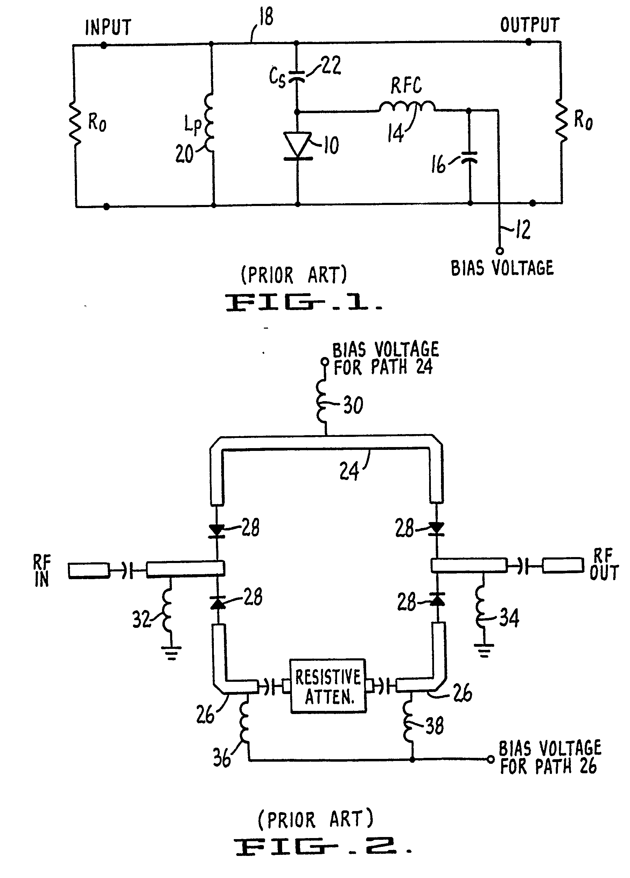

In Figure 1 a prior art step attenuator is shown. In this configuration a pin diode 10 is provided with selected magnitudes of bias voltages via line 12, radio frequency choke 14, and bypass capacitor 16. In this manner, depending upon the forward DC voltage applied pin diode 10 can be biased to present a variety of selectable magnitudes of resistance in parallel with the RF signal path 18. In Figure 1 the characteristic impedance of the RF signal path 18 is $R_o$. Whenever the pin diode 10 is biased for a resistance having a magnitude different from $R_o$, a mismatch is set up in the signal path 18. This causes a portion of the signal, which impinges upon the diode, to be reflected back to the input port with the remainder of the signal being transmitted to the output port. From Figure 1 it can be seen that no provision is provided for dissipation of this reflected input signal component.

Another drawback of this configuration is the requirement for precise biasing voltages and a prior knowledge of the bias voltage to resistance relationship of each pin diode.

Moreover, temperature comensation is also required to correct for drifts in the diode resistance due to temperature variations.

A further drawback of this configuration is the need to resonate the intrinsic inductance 20 of the pin diode 10 in its off state. Capacitor 22 is shown connected in series with pin diode 10 in order to effectuate this requirement. As a result of this resonant condition, the bandwidth of the configuration is greatly limited.

Figure 2 illustrates another prior art step attenuator configuration. In this configuration, the RF signal is switched between one of two signal paths 24 and 26 by way of series connected pin diodes 28. The pin diodes are switched on and off by way of biasing voltages. The biasing voltage to signal path 24 is supplied through radio frequency chokes 30, 32, and 34, while biasing voltages for path 26 are supplied through radio frequency chokes 36 and 32 as well as 38 and 34.

In this configuration, signal path 24 does not provide any attenuation to the input signal, while path 26 provides resistive attenuation in series with the signal path. Typically, this rseistive attenuation takes the form of a pi or tee network in order to maintain the characteristic impedance of the signal path, and thus avoid any reflected waveforms.

In the configuration of Figure 2, it can be seen that the pin diodes in signal path 24 are required to handle the full power of the input signal. As such, the maximum power capable of being handled by such an attenuator is limited by the power dissipation capabilities of these pin diodes. Additionally, because the pin diodes are handling signals of such high power level, switching these diodes from an on to an off state is a significant problem which limits the speed by which the attenuator can be switched from one level of attenuation to the next.

Figure 3 is a simplified function block diagram on the present invention. As shown, the present invention is connected in a microwave transmitting system which includes a transmitter 66 as the input signal source, and a duplexer 61 and a number of antennas 63 as the load for the attenuated signal. The transmitter supplies control signals to control circuitry 84 which in turn selects the attenuation desired. The input signal is applied from the transmitter 66 via an input port 40 to a signal splitter 42. The signal splitter 42 divides the input signal into first and second signal of substantially equal magnitude but different phase. The first and second signals are output from the splitter via a first output port 44 and a second output port 46, respectively. Connected to the first and second output ports 44 and 46, are mismatch circuits 48 and 50. These are controlled by signals on lines 52 from control circuit 84 by which the mismatches can be removed or connected to the first and second output ports 44 and 46.

When the mismatches are applied, a portion of the signal emerging from the output ports 44 and 46 are reflected back into the signal splitter 42. The remaining portion of the signal is transmitted to summing circuit 54. Summing circuit 54 operates on the transmitted signals so that they are placed in an in-phase relationship with each other at the summing circuit output port 56. By proper selection of the degree of mismatch introduced by mismatch circuits 48 and 50, a selectable attenuation of the signal can be obtained.

The waveforms which are reflected back into the signal splitter 42 are routed by signal splitter 42 to a termination port 59 where the signals are dissipated in a match load. No portion of the reflected signals appears at input port 40 because the phase relationships of the signal paths within the signal splitter 42 cause the reflected waveforms to cancel one another at the input port 40.

Thus, generally, the present invention implements a method of high power, high frequency, high speed step attenuation by splitting the input signal into two signals having substantially the same magnitude but different phases; by subjecting the signals to a selected mismatch so that a portion of the signals are reflected back towards the input part of the attenuator and the remaining portion transmitted to a summing circuit; by adjusting the phase of the transmitted portions of the signal so that they are in phase with one-another at the output of the summing circuit; by isolating the input port of the attenuator from the reflected waveforms due to the mismatches; and by dissipating the reflected waveforms in a matched, termination load. In one implementation of this method, the mismatches are switched in and out of the signal paths by way of pin diodes.

Referring to the Figure 4, a more detailed description of the preferred embodiment of the present invention will now be provided. It is to be understood in connection with this more detailed explanation, that the emodiment described is only one of many possible implementations of the teachings of the present invention. For example, there are a number of ways in which to implement the signal splitter 42, the mismatches 48 and 50, or the summing circuit 54, of Figure 3, which would change the physical structure of the attenuator, but nonetheless implement the teaching of the present invention.

Figure 4 illustrates an embodiment of the present invention which provides attenuation of high power signals in one decibel (dB) selectable steps from zero dB to 41 dB. In order to achieve this range of attenuation, three stages, 58, 60 and 62, of the basic attenuator circuit are connected in series. A detailed description will be given of the basic attenuator circuit, it being an obvious step to select the mismatch values to form a particular stage in the overall attenuator, as well as to connect the various attenuator stages in series.

Referring to attenuator stage 58, the basic attenuator circuit will be described in greater detail.

Preliminarily, with respect to the embodiment being discussed, it is assumed that the characteristic impedance of the system in which the step attenuator circuit is to be used is 50 ohms. Thus, the signal paths of the step attenuator are designed for a 50 ohm system. It is to be understood where the characteristic impedance of the system in which the step attenuator is located differs, that the characteristic impedance of the step attenuator can be adjusted accordingly.

The signal splitter 42

In Figure 4, it can be seen that the signal splitter 42 of Figure 3 takes the form of a 3 dB quadrature coupler 64. As is well known in the art, a 3 dB quadrature coupler, such as coupler 64, provides to port 44, via signal path 68, a signal which has been shifted in phase by 90 degrees from the input signal, and reduced in magnitude by 3 dB. Similarly, the signal path shown by arrow 70 provides to output port 46 a signal which has not been shifted in phase with respect to the input signal, but which has a magnitude which is 3 dB below the input signal magnitude. Signal path 68 imparts a 90 degree phase shift by causing the input signal to electrically propagate along a quarter wavelength distance. The signal path 70 between input port 40 and output port 46 takes the form of electromagnetic coupling between signal path 68 and signal paht 72, hence there is no phase shift due to such a path.

Signal path 72 connects output port 46 to termination port 59. Signals travelling along this path are shifted in phase by 90 degrees due to the quarter wavelength of the path. The signal path is provided between output port 44 and termination port 59 via the electromagnetic signal path indicated by arrows 74. In both signal paths 70 and 74, the degree of the electromagnetic coupling along each path causes each resulting signal magnitude to be 3 dB below that of the input signal.

In operation, the input signal is introduced at input port 40 and caused to propagate to output port 44 via signal path 68, and to output port 46 via signal path 70. The signal appearing at output port 44 is shifted in phase by 90 degrees and, due to the coupling between signal path 68 and signal path 72, has a magnitude 3 dB below the input signal magnitude. The signal presented to output port 46 is 3 dB below the input signal magnitude but is of the same phase as the input signal.

Upon the presence of a mismatch, i.e. an impedance different from the characteristic impedance of the system, at each of the output ports 44 and 46, a portion of the signal at each of the output ports will be reflected back into the coupler 64. Where the mismatch at each output port is of the same degree, the magnitudes of the waveforms reflected back into the 3 dB coupler 64 will be the same. The reflected waveform into output port 44 will propagate back down signal path 68 to input port 40 and incur an additional 90 degree phase shift. Thus the reflected signal from output port 44 which is presented to input port 40 will be 180 degrees out of phase from the input signal.

The reflected signal into output port 46 will be coupled via signal paths 70 back to input port 40. This reflected waveform will incur no phase shift upon retracing signal path 70, and will therefore be in phase with the input signal. Because the magnitudes of the two reflected waveforms are the same and because the two waveforms are 180 degrees out of phase at the input port 40, they will cancel one-another. The input port 40 is thus isolated from any reflected waveforms which enter output port 44 and 46 as a result of mismatches at these ports.

While the reflected waveforms are self-cancelling at input port 40, signal paths 72 and 74 route these reflected waveforms to termination port 59 for dissipation in a matched load 76. The reflected waveform into output port 44 is coupled via signal path 74 to termination port 59. As explained above, there is no phase shift across this path. Thus, the signal at termination port 59 due to the reflected signal at output port 44 is 90 degrees out of phase from the original input signal. The reflected signal from output port 46 is coupled to termination port 59 via signal path 72. As discussed above, a signal transversing signal path 72 will incur an additional 90 degree phase shift. As such, the signal at termination port 59 due to the reflected waveform from output port 46 will be 90 degrees out of phase from the input signal. Thus it can be seen that the reflected signals presented to dissipation port 59 will be in phase with each other.

Termination load 76, for this embodiment is a 50 ohm load, and is designed to dissipate these reflected waveforms.

Thus it can be seen that by the structure of quadrature coupler 64, input port 40 is isolated from reflected waveforms into output ports 44 and 46, while termination port 59, in conjunction with termination load 76 dissipates all of the reflected waveforms.

### The mismatch means 48, 50

In this embodiment of the present invention, mismatch means 48 and 50 are provided at output ports 44 and 46 of coupler 64 by way of resistive elements connected in series with pin diode switches. The series combination of pin diode switch and resistive element are applied in parallel to the signal paths. In Figure 4 two pairs of mismatch elements 77 and 86 are shown connected to output ports 44 and 46 of coupler 64. For purposes of illustration, consider the mismatch element 77 formed by resistor 78, capacitor 80, and pin diode 82. These three components are connected in series. Resistor 78 provides the impedance mismatch to the signal path, while capacitor 80 is a DC blocking capacitor as well as a resonating capacitor. Diode 82, when forward biased, connects resistor 78 in parallel with output port 44. When diode 82 is reversed biased, resistor 78 is taken out of the signal path.

The forward or reverse biasing of diode 82 is performed by driver circuit 83. In the typical application, each mismatch element would have a pin diode switch which is controlled by a driver circuit. These drivers would be contained within a control circuit 84, which in turn receives control signals from the operating system, such as a transmitter 66. See Figure 3. Each driver circuit would be controlled by the operating system and the output of each driver would be selected by the operating system so that particular combinations of mismatches would be inserted into the corresponding signal paths to produce the desired amount of attenuation.

In the preferred embodiment of the present invention, the pin diode driver provides an initial high current spike to overcome the internal capacitance of the diode, followed by a steady state DC voltage to hold the diode in either a forward biased or reversed biased state. Because in the present invention the operating power levels are significantly lower for the various diode switches, as compared to prior step attenuator designs, the switching speed of the diodes can be significantly improved. In practice switching speeds of better than one microsecond have been achieved where the power of the input signal is on the order of two kilowatts.

The value of capacitor 80 is selected to resonate with the intrinsic inductance of the pin diode 82 in its on state. Due to the series connection of the diode in the mismatch element circuit, the effects of the internal inductance of the diode are not as pronounced as in the circuits of the prior art. Thus, the bandwidth of a step attenuator built according to the teaching of the present invention is at least an octave wide.

As can be seen from Figure 4, there is a mismatch element disposed at output port 46 which is substantially identical in component value to that disposed at output port 44. This is to provide substantially the same degree of mismatch at each of the output ports 44 and 46 so as to permit the cancellation of the reflected waveforms at input port 40 as discussed above.

In the preferred embodiment of the present invention, a second pair 86 of mismatch elements are positioned at output ports 44 and 46. This mismatch pair 86 provides a different degree of impedance mismatch. In the preferred embodiment of the invention the first pair of mismatched elements utilize a 200 ohm resistive element for a mismatch which provides approximately 1 dB of attenuation, while the second mismatch pair 86 utilizes a 90 ohm resistive element to provide a mismatch which corresponds to approximately 2 dB of attenuation.

In operation, these mismatched elements can be connected into the signal paths either singly or in combination, to thereby obtain attenuations of 1 dB, 2 dB or 2.8 dB.

The attenuation of a resistor element, R, in parallel with a transmission line with characteristic impedance Ro is given by the equation

$$10 \log_{10}(4/(\frac{Ro}{R}+2)^2) \text{ dB.}$$

Thus it can be seen that the values of the resistive elements can be chosen for an infinite number of different attenuation values. In the preferred embodiment of the present invention, the resistive elements of the first stage 58 are chosen to provide 1 dB, 2 dB and 2.8 dB of attenuation. The resistive elements of the second stage 60 are chosen to provide 4 dB, 8 dB or 9.8 dB of attenuation. Finally, the resistive elements of the third stage 62 are chosen to provide 14 or 28 dB of attenuation. By connecting combinations of mismatch elements in each of the stages 58, 60 and 62, it can be seen that an attenuator is obtained which provides attenuation in steps of 1 dB in the range of 0 dB to 41 dB.

The summing means 54

Returning to stage 58 and Figure 4, the summing circuit 54 of Figure 3 is implemented by way of a second 3 dB quadrature coupler 88. This coupler 88 is used in what can be termed a mirror image of coupler 64. The signal transmitted through the mismatch on signal path 90 is received by input port 94 of coupler 88. Recall that the signal on signal path 90 corresponds to the transmitted portion of the signal from output port 44 of coupler 64 which has been subjected to an impedance mismatch by either mismatch element 77 and/or 86. As received by input port 94, the signal is phase shifted by 90 degrees from the original input signal at input port 40 of coupler 64. Input port 96 receives the transmitted signal on signal path 92. Recall that the signal on signal path 92 is in phase with the input signal originally applied to port 40 of coupler 64, and is the transmitted portion of the signal from output port 46 of coupler 64 which has been subjected to the corresponding mismatch combination of mismatch element 77 and/or 86.

As with coupler 64, quadrature coupler 88 provides signal paths which shift the phase of the signals travelling thereon depending upon the ports between which the signals are travelling. As can be seen from Figure 4, the output port of coupler 88 is selected so that the signal entering the input port 94 will follow signal path 98 and hence, will receive no phase shift. On the other hand, the signal inserted at input port 96 will propagate down signal path 100 and, as a result, be phase shifted by 90 degrees. As a consequence, the two signals will be in-phase at output port 97 of coupler 88. Thus, coupler 88 provides a phase shifting of the input signals and a summation of the phase shifted signals so that the resulting output signal at output port 97 is reduced in magnitude from the magnitude of the input signal applied to input port 40 by an amount of attenuation determined by mismatch elements 77 and/or 86.

Termination port 102 of coupler 88 is terminated in a 50 ohm load. From Figure 4 it can be seen that there is no signal dissipation in this termination due to the phase relationship of the signals at that port. That is, the signal applied to input port 94 will be shifted by 90 degree at port 102, while the signal applied to input port 96 will not be shifted in phase. The result is one signal which is phase shifted by 180 degrees from the original input signal at input port 40, and another signal which is in phase with the original input signal at input 40 such that the two signals cancel each other at termination port 102 of coupler 88.

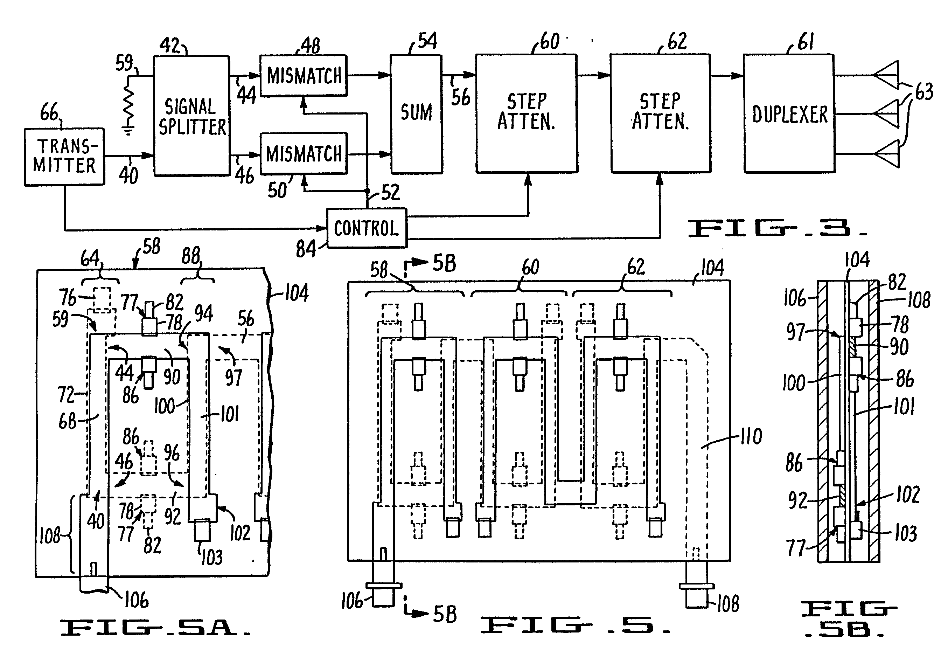

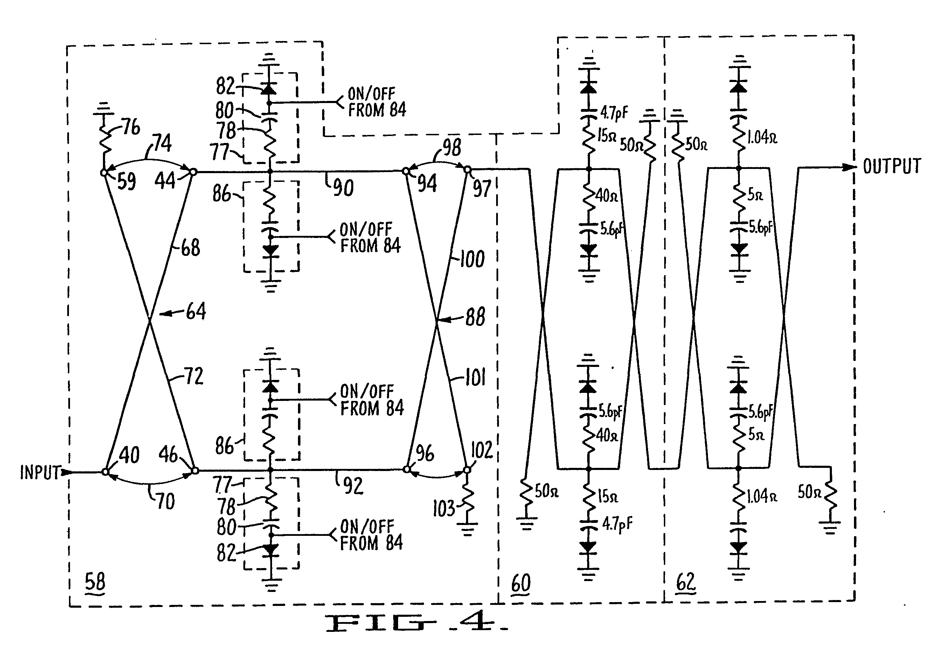

Referring to Figure 5, a physical implementation of one embodiment to the present invention will now be described. This implementation utilizes stripline transmission line techniques for use in the 16 Hz frequency range. As can be seen from the figure the three stages of attenuation can be packaged tightly for a small space requirement. In one embodiment of the present invention similar to that shown in Figure 5, the horizontal dimension is approximately 82 mm ($3\frac{1}{4}$ inches), the vertical dimension is approximately 64 mm ($2\frac{1}{2}$ inches), and the depth is approximately 13 mm ($\frac{1}{2}$ inch).

In the implementation shown in Figure 5 two sides of a dielectric sheet 104 are utilized, with circuit traces on either side. In Figure 5, the top view is shown with traces and components found on the top side drawn in solid lines, and with the traces and components found on the bottom of the sheet 104 bottom shown in dashed lines.

Figure 5B is a side view of the embodiment of Figure 5 which shows the placement of the ground planes 106 and 108 which form a part of the stripline transmission line. Figure 5B illustrates the manner in which the signal traces of stripline are position on either side of the dielectric sheet 104, and sandwiched between ground planes 106 and 108.

Figure 5A is a expanded view of section 58 of Figure 5. For purposes of illustration, the relative sizes of the various components and circuit traces are exaggerated. As in Figure 5, traces and components which are found on the top side of the dielectric sheet 104 are drawn with solid lines while the traces and components found on the bottom side of the dielectric sheet 104 are drawn in dotted lines. Additionally, the reference numerals utilized in discussing the schematic diagram of Figure 4 are also utilized in discussing the physical circuit of Figure 5A. This is to facilitate the association of the physical components of the embodiment in 5A with the schematic representation of the components in Figure 4.

Referring to the left side of Figure 5A it can be seen that the signal splitter 42 of Figure 3, or the quadrature coupler 64 of Figure 4, is formed by the trace segment on the top side of the board with reference numeral 68, and the trace segment on the bottom side of the board with reference numeral 72. The input port to quadrature coupler 64 is on the top side of the board and indicated by reference numeral 40. The first output port, from which is obtained the signal which is phase shifted by 90 degrees from the signal at the input port 40, is found at the other end of trace segment 68 and indicated by reference numeral 44.

With respect to trace segment 72 on the bottom side of the board, the second output port, which provides the signal which is in phase with the signal presented at input port 40, can be found aligned with input port 40 and labelled with reference numeral 46. At the other end of trace segment 72 is found the termination port 59. Note that the termination port 59 is disposed beneath the first output port 44. Note also that trace segment 68 is disposed directly above trace segment 72.

In Figures 5 and 5A, the top and bottom circuit traces are shown slightly offset from their actual position in the embodiment of the invention. This offset is provided in the drawings to assist in the visual understanding of the relative position of the traces.

The input signal is supplied to input port 40 of quadrature coupler 64 by trace segment 108, which is a length of stripline transmission line having a characteristic impedance of 50 ohms, via a Type SMA connector 106. In practice, connector 106 can be any connector suitable for connecting high frequency signals from a cable or other signal line device to a circuit board trace.

The length of trace segment 68 and of trace segment 72 is selected to be approximately a quarter wave length of the frequency of the signal being attenuated. In the case of the embodiment shown in Figure 5, a signal of approximately 1 GHz is desired to be attenuated thus indicating a quarter wave length of approximately 1½ inches. By positioning trace segments 68 and 72 in the manner shown in Figure 5A, both electromagnetic and electrical coupling are obtained between the various ports of the coupler.

An electrical coupling is obtained between input port 40 and output port 44 as the signal propagates down trace segment 68. Because the trace segment is a quarter wave length long, the signal is shifted by 90 degrees at output port 44.

There is an electromagnetic coupling between input port 40 and output port 46 through the dielectric sheet 104. Because output port 46 is aligned with input port 40, there is no phase shift as the signal is coupled between these ports. There is also an electromagnetic coupling between output port 44 and termination port 59. Because output port 44 is aligned with termination port 59, there is no phase shift as the signal propagates between the ports.

There is, however, a phase shift as the signal propagates electrically between output port 46 and termination port 59 along trace segment 72. This is because the length of trace segment 72 is also a quarter wave length.

The width of both trace segment 72 and trace segment 68, as well as the dielectric material and spacing between trace segments 72 and 68, are chosen so that the signal which propagates electrically along each trace segment and the signal which is coupled electromagnetically between aligned ports have the same magnitude. Thus, for an input signal at port 40 which has a given magnitude, the signal which emerges from port 44 will have a magnitude which is 3 dB lower than the input signal and a phase which is shifted by 90 degrees from the input signal. Similarly, the signal which emerges at output port 46 will have a magnitude which is 3 dB lower than the magnitude of the input signal and a phase which is the same as the input signal.

As discussed above, an advantage of splitting the signal into two separate signals having the same magnitude before actual attenuation is performed, is that the amount of stress to which the attenuating components are subjected is significantly reduced. Additionally, this splitting of the input signal and the phase shifting of one split signal with respect to the other, by way of a quadrature coupler, permits a mismatch type of attenuation to be performed. This is because any reflected signals, due to the mismatches imposed, will be reflected back into the quadrature coupler 64 but phase-shifted by the coupler in such a way that the input port 40 is isolated from such reflected waveform, while the termination port 59 receives all of the reflected wave form magnitude for dissipation of the reflected waveforms there. This isolation and dissipation of the reflected wave forms is based upon the assumption that the reflected waveforms which propagate back through the quadrature coupler 64 to the input port 40 are impressed with a phase and magnitude such that they cancel one another out at the input port 50. Conversely it is assumed that, as the reflected signals propagate back through the quadrature coupler 64 toward the termination port, they are impressed with a phase shift and magnitude such that the sum of the reflected signals at termination port 59 is maximized, for complete attenuation of all of the reflected signals at termination port 59.

It is to be understood that so long as the above discussed isolation and dissipation results occur, it is not necessary that a quadrature coupler be utilized. Thus, any coupler which provides the requisite isolation of the input port from the two output ports with respect to waveforms reflected back into the output ports, and which provides the requisite dissipation of the reflected waveforms, would be satisfactory for use in the present invention. Additionally, it is to be understood that the teaching of the present invention is not limited to splitting the input signal into two equal parts. Rather, it is the concept of reducing the signal magnitudes presented to the attenuating components by splitting the input signal into several parts, however many that may be, which is one of the teachings of this invention.

Remaining with Figure 5A, the reduced magnitude and phase-adjusted signals which emerge from output ports 44 and 46 of quadrature coupler 64 are propagated along 50 ohm trace segments 90 and 92 respectively. Disposed in parallel with these trace segments are the mismatch circuits described in connection with Figure 4. At the top of Figure 5A it can be seen that one end of resistive element 78 is electrically connected to trace segment 90 and that the other end is connected to one end of pin diode 82. The other end of pin diode 82 is connected to the ground plane 108. The illustration of Figure 5A has been simplified to facilitate the description of the physical embodiment of the invention. As such, the DC blocking capacitor 80 and the connection to the diode driver 84 shown in Figure 4 have been omitted.

Mismatch circuit 86 is disposed on trace segment 90 opposite mismatch circuit 77. As described in connection with Figure 4, the value of the resistive element of mismatch circuit 86 is selected to provide a different degree of impedance mismatch than that presented by resistive element 78 of mismatch circuit 77. With respect to trace segment 92, it can be seen that there is a corresponding mismatch circuit 77 and a corresponding mismatch circuit 86 positioned thereon.

In operation, when a mismatch is sought to be introduced in trace segments 90 and 92, the pin diode corresponding to the particular resistive element is forward biased by driver circuit 84. This connects the desired resistive elements in parallel with the trace segments to form a mismatch of impedance in the signal paths. In response to this, a portion of the signals propagating on trace segments 90 and 92 is reflected back to quadrature coupler 64 while the remaining portion is permitted to continue on to quadrature coupler 88. Recall that quadrature coupler 88 corresponds to the summing circuit 54 of Figure 3. As discussed above, the amount of mismatch imposed upon signal paths 90 and 92 determines the amount of attenuation eventually achieved by the attenuation stage. Thus, the selection, either individually or in combination, of mismatch circuits 77 and 86 provides a selectable number of steps of attenuation. In one embodiment of the present invention the resistive element for mismatch 77 is selected to be 96 ohms while the resistive element for mismatch element 86 is selected to be 208 ohms. Connection of mismatch circuit 86 in parallel with trace segments 90 and 92 produces a 1 dB attenuation while connection of the mismatch circuit 77 produces a 2 dB attenuation. Connection of both mismatch circuits 77 and 86 produces a 2.8 dB attenuation. In a similar manner, by selecting the values of the resistive element, one can obtain any degree of attenuation in any step size magnitude desired.

It is to be understood that while resistive elements, such as chip resistors are utilized in the embodiment discussed above, other resistive elements, such as appropriately biased pin diodes can be used satisfactorily with the present invention.

It is also to be understood that while the preceding discussion has assumed that the quadrature coupler 64 splits the input signal into two signals having equal magnitude, it is also possible to select the mismatch circuits associated with trace segments 90 and 92 such that a signal splitter which produces split signals of different magnitudes can be used. In such a situation, the mismatch circuits would be chosen so that the magnitude of reflection obtained thereby for each trace segment would be set so that there would be a cancellation of the reflected waveform at the input port to the splitter and a total dissipation of the reflected waveforms at the termination port.

If no attenuation is desired, all of the pin diodes associated with the mismatch circuits would be reversed biased so as to remove the resistive elements from parallel connection with trace segments 90 and 92.

The transmitted portion of the signals propagating along trace segments 90 and 92 are received by input port 94 and 96 respectively of quadrature coupler 88. It can be seen from Figure 5A that this coupler is implemented in much the same manner as quadrature coupler 64. The application of this coupler, however, is reversed from that of quadrature coupler 64. Here, the coupler is used to shift the phase of the signal from input port 96 by 90° by causing that signal to propagate down trace segment 100 to output port 97. The signal from trace segment 90, which is received at input port 94, is electromagnetically coupled to output port 97 with no phase shift. As a result, the signal appearing at output port 97 is the sum of the magnitudes of the two signals received at input ports 94 and 96. Termination port 102 of quadrature coupler 88 is terminated by a 50 ohm load impedance. Due to the operation of the coupler, the signals from input port 94 and 96 cancel each other at termination port 102.

The result of the above is that a signal is obtained at output port 97 which is attenuated from that introduced at input port 40 by an amount determined by the selected mismatched circuits 77 and/or 86.

Thus, there is implemented a method of attenuation in which an input signal is first split into two separate signals having magnitudes which are less than the magnitude of the input signal and the sum of which equal the magnitude of the input signal. These signals are then subjected to mismatches as they propagate along a signal path so that a portion of each signal is reflected back to the signal splitter while the remaining portion is transmitted to a summing circuit. The reflected portion of the waveforms are dissipated by the splitting circuit and isolated from the input port. The transmitted portions of the split signals are recombined in the summing circuit and output to the next stage of attenuation. By providing signals having reduced magnitudes to the mismatch circuits, the components utilized in the mismatch circuits are subjected to lower signal levels, and, as such, can be switched in and out of the circuit more quickly. The components are also subject to less chance of component failure due to over stress.

The second and third stages 60 and 62 of the attenuator are implemented in a manner similar to that of attenuation stage 58. The difference between the stages being in the value of the resistive elements selected for each mismatch circuit. Each of the stages is connected in series, with the attenuation of each stage being additive with those of the other stages. In operation, some attenuation may be provided by each of the stages, or all of the attenuation may be provided by one of the stages. Similarly, were no attenuation is desired, none of the mismatch circuits of the three stages are connected in the circuit. The output of the three stage attenuator shown in Figure 5 is supplied to a type SMA connector 108 via 50 ohm trace segment 110 for output to the remainder of the system. In the embodiment of the present invention, in which one 1 dB steps over a range from 0 to 41 dB are obtained, the value of the resistive elements in stages 60 and 62 are shown in Figure 4. Also shown are the values of the DC blocking capacitances.

It is to be understood that while the present invention has been explained in terms of stripline transmission lines, other circuit implementations can be utilized with equal success. For example, microstrip transmission lines can be used. The particular circuit medium in which the present invention is implemented is a function of the frequency which is sought to be attenuated.

It is also to be understood that the theoretical frequency and power handling capabilities of the present invention are limited only by the medium in which the invention is implemented. For example, the chip resistors shown in Figure 5 have limited application at very high frequencies such as 40 GHz. It is conceivable, however, that a resistive element suitable for use at 40 GHz could be found and utilized in the present invention. Similarly, for high power embodiments, the power handling capabilities of the various components would simply be increased.

The above invention thus provides a step attenuator which is capable of handling high power, high frequency signals and which is also capable of switching between values of attenuation at high speed. In doing so, the component count with respect to prior art step attenuators has been reduced, the stress upon each component has been reduced, the speed of switching between attenuation steps has been increased, the size of the overall step attenuator has been decreased, and the overall complexity of the circuit has been significantly reduced.

The terms and expressions which have been employed here are used as terms of description and not of limitation, and there is no intention, in the use of such terms and expressions of excluding equivalents of the feature shown and described, or portions thereof, it being recognized that various modifications are possible within the scope of the invention claimed.

## Claims

1. Apparatus for attenuating a high frequency electromagnetic input signal having a predetermined power magnitude comprising

means (64) responsive to the input signal for splitting the input signal into a first signal and a second signal, each having a predetermined magnitude the sum of which is substantially equal to the input signal magnitude, the input signal splitting means having a first output port (44) for outputting the first signal, and a second output port (46) for outputting the second signal, the input port (40) being isolated from the first and second output ports (44, 46) in that waveforms reflected from the first and second output ports (44, 46) and back into the input signal splitting means (64) cancel one another at the input port (40) and are additive with one another at a termination port (59) for dissipation in a termination (76);

mismatch means in communication with the first and second output ports (44, 46) for providing an adjustable impedance mismatch at each output port (44, 46) so that a portion of the first signal from the first output port (44) and a portion of the second signal from the second output port (46) are reflected back into the input signal splitting means (64) for dissipation therein, and so that the unreflected portion of each of the first and second signals are transmitted, said mismatch means comprising:

a first length of stripline transmission line (90) electrically connecting the first output port (44) to a recombination means (88);

a second length of strip line transmission line (92) electrically connecting the second output port to the recombination means (88) and mismatch means for controlling the degree of impedance mismatch, said mismatch means comprising first and second resistance means (77, 86) which produce said degree of impedance mismatch and which are arranged in parallel with the first and second lengths of transmission line (90, 92), respectively, characterized in that said

first and second resistance means are fixed resistance means (77, 86) which are selectably connectable in parallel with the respective length of transmission line (90, 92); and

connection means (82) are provided for said selectable connection of the first and second fixed resistance means (77, 86) to the first and second lengths of transmission line (90, 92).

2. Apparatus of Claim 1 characterized in that the input signal splitting means (64) comprises

a first quarter wavelength stripline transmission line (68) having one end electrically connected to the input port (40) and its other end electrically connected to the first output port (44);

a second quarter wavelength stripline transmission line (72) having one end electrically connected to the dissipating termination port (59) and its other end electrically connected to the second output port (46);

wherein the second transmission line (72) is positioned in a hypothetical plane which is spaced apart from but parallel to the plane of the first transmission line (68), so that the input signal is electromagnetically coupled from the input port (40) to the second output port (46) with no phase shift and a power magnitude which is 3 dB lower than the input signal power magnitude and so that the input signal is electrically coupled to the first output port (44) with a 90 degree phase shift and a magnitude 3 dB lower than the input signal magnitude; and

further wherein a first reflected waveform, having a power magnitude and a phase, which is inserted into the first output port (44) will be cancelled at the input port (40) by, and dissipated at the termination port (59) in conjunction with a second reflected waveform having the same power magnitude as the first waveform and shifted 90 degrees in phase from the first waveform and which is inserted into the second output port (46).

3. Apparatus of Claim 1 or 2 wherein the first and second fixed resistance means (74, 86) each comprise a chip resistor having a predetermined resistance, and further wherein, the selective connecting means comprise

a first pin diode (82) connected in series with the first chip resistor (78);

a second pin diode (82) connected in series with the second chip resistor (78);

and biasing means (84) for selectively reverse biasing the first and second pin diodes (82) to rapidly disconnect the first and second resistance means (77, 86) from the first and second lengths of transmission line (90, 92), and for selectively forward biasing the first and second pin diodes (82) to rapidly connect the first and second resistance means (78, 86) to the first and second lengths of transmission line (90, 92).

4. Apparatus of Claim 1, 2 or 3 wherein the recombining means (88) comprises a quadrature coupler having a first input port (94) responsive to the first signal, a second input port (96) responsive to the second signal, an output port (97), and a termination port (102), wherein the first input port (94) is electrically connected to the output port (97) and electromagnetic coupled to the termination port (102), and further wherein the second input port (96) is electromatically coupled to the output port (97) and electrically connected to the termination port (102), so that the first and second signals are combined within the recombining means (88) for output from the output port (97).

5. Apparatus of any of Claims 1 to 4 wherein the first fixed resistance means (77, 86) include a first plurality of lumped resistance elements (78) each of which is selectably connectable in shunt with the first length of transmission line (90); and further wherein the second fixed resistance means (77, 86) include a second plurality of lumped resistance (78) elements each of which is selectably connectable in shunt with the second length of transmission line (92); each of the first plurality of lumped resistance elements (78) having substantially the same values of resistance as corresponding ones of the second plurality of lumped resistance elements (78) so that by selecting corresponding resistance elements (78) from the first and second plurality of resistance elements (78) an impedance mismatch having a selectable magnitude can be created.

6. Apparatus of Claim 3 wherein the biasing means (84) comprise a first driver means for driving the first pin diode (82) and a second driver means for driving the second pin diode (82); each driver means providing an initial high current spike and a subsequent steady state biasing voltage so that the pin diodes (82) can be switched between off and on states with a minimum of delay.

7. Method for the attenuation of a high frequency, high power electromagnetic input signal comprising the following steps:

splitting the input signal into a first split signal and a second split signal by way of a first coupler means wherein the first split signal is shifted in phase from the second split signal by a predetermined amount and both split signals have substantially equal power magnitudes, the total of which substantially equals the input signal power magnitude;

applying the first and second split signals to a variable impedance mismatch so that a portion of the first and second split signals is reflected and a portion is transmitted to a second coupler means, the first coupler means then dissipating the reflected signal portions internally; and

recombining the transmitted portion of the split signal in a second coupler means by phase shifting one of the split signals to be substantially equal in phase to the other split signal and by adding the resulting signals together, said variable imepdance mismatch being selected so that the sum of the power magnitudes of the transmitted portions of the split signals corresponds to the input signal power magnitude which has been attenuated by a desired amount;

characterized in that for attenuating said input signal in selectable steps said first and second split signals are applied to a selectable impedance mismatch comprising fixed resistive means.

**Patentansprüche**

1. Vorrichtung zum Dämpfen eines hochfrequenten elektromagnetischen Eingangssignals, welches eine vorherbestimmte Leistungsgröße hat, mit

auf das Eingangssignal ansprechenden Einrichtungen (64) zum Teilen des Eingangssignals in ein erstes Signal und ein zweites Signal, die jeweils eine vorherbestimmte Größe haben, deren Summe im wesentlichen der Eingangssignalgröße gleich ist, wobei die Eingangssignalteileinrichtungen einen ersten Ausgangsanschluß (44) zur Ausgabe des ersten Signals und einen zweiten Ausgangsanschluß (46) zur Ausgabe des zweiten Signals haben, wobei der Eingangsanschluß (40) gegenüber dem ersten und zweiten Ausgangsanschluß (44, 46) insofern isoliert ist, als vom ersten und zweiten Ausgangsanschluß (44, 46) und zurück in die Eingangssignalteileinrichtungen (64) reflektierte Wellenformen einander am Eingangsanschluß (40) aufheben und miteinander additiv sind an einem Abschlußanschluß (59) zur Vernichtung in einem Abschluß (76);

Fehlanpassungseinrichtunge in Verbindung mit dem ersten und zweiten Ausgangsanschluß (44, 46) zur Schaffung einer einstellbaren Impedanzfehlanpassung an jedem Ausgangsanschluß (44, 46), so daß ein Teil des ersten Signals vom ersten Ausgangsanschluß (44) und ein Teil des zweiten Signals vom zweiten Ausgangsanschluß (46) zurück in die Eingangssignalteileinrichtungen (64) zur Vernichtung darin reflektiert werden, und so, daß der unreflektierte Teil jedes der ersten und zweiten Signale übertragen werden, wobei die Fehlanpassungseinrichtungen folgendes aufweisen:

eine erste Länge einer Streifenleitungsübertragungsleitung (90), die den ersten Ausgangsanschluß (44) elektrisch an eine Rekombinationseinrichtung (88) anschließt;

eine zweite Länge einer Streifenleitungsübertragungsleitung (92), die den zweiten Ausgangsanschluß an die Rekombinationseinrichtung (88) elektrisch anschließt und Fehlanpassungseinrichtungen zum Steuern des Ausmaßes der Impedanzfehlanpassung, wobei diese Fehlanpassungseinrichtungen erste und zweite Widerstandseinrichtungen (77, 86) aufweisen, die das genannte Ausmaß an Impedanzfehlanpassung erzeugen und parallel zur ersten bzw. zweiten Länge der Übertragungsleitung (90, 92) angeordnet sind, dadurch gekennzeichnet, daß die ersten und zweiten Widerstandseinrichtungen Festwiderstandseinrichtungen (77, 86) sind, die wahlweise parallel zur entsprechenden Länge der Übertragungsleitung (90, 92) schaltbar sind; und Verbindungseinrichtungen (82) vorgesehen sind für die wahlweise Verbindung der ersten und zweiten Festwiderstandseinrichtungen (77, 86) mit der ersten und zweiten Länge der Übertragungsleitung (90, 92).

2. Vorrichtung nach Anspruch 1, dadurch gekennzeichnet, daß die Eingangssignalteileinrichtung (64) folgendes aufweist:

eine erste Viertelwellenlänge-Streifenleitungsübertragungsleitung (68), die mit einem Ende mit dem Eingangsanschluß (40) und mit ihrem anderen Ende mit dem ersten Ausgangsanschluß (44) elektrisch verbunden ist;

eine zweite Viertelwellenlänge-Streifenleitungsübertragungsleitung (72), die an einem Ende mit dem vernichtenden Abschlußanschluß (59) und an ihrem anderen Ende mit em zweiten Ausgangsanschluß (46) elektrisch verbunden ist;

worin die zweite Übertragungsleitung (72) in einer hypothetischen Ebene angeordnet ist, die einen Abstand von der Ebene der ersten Übertragungsleitung (68) hat, aber parallel dazu ist, so daß das Eingangssignal vom Eingangsanschluß (40) zum zweiten Ausgangsanschluß (46) elektromagnetisch gekoppelt wird ohne Phasenverschiebung und einer Leistungsgröße, die 3 dB niedriger ist als die Eingangssignalleistungsgröße, und so daß das Eingangssignal mit dem ersten Ausgangsanschluß (44) elektrisch gekoppelt wird mit einer 90°-Phasenverschiebung und einer Größe, die 3 dB niedriger ist als die Eingangssignalgröße; und

worin ferner eine erste reflektierte Wellenform, die eine Leistungsgröße und eine Phase hat, welche in den ersten Ausgangsanschluß (44) eingefügt wird, am Eingangsanschluß (40) aufgehoben wird durch und am Ausgangsanschluß (59) vernichtet wird in Zusammenhang mit einer zweiten reflektierten Wellenform, die die gleiche Leistungsgröße hat wie die erste Wellenform und gegenüber der ersten Wellenform um 90° phasenverschoben ist und die in den zweiten Ausgangsanschluß (46) eingefügt wird.

3. Vorrichtung nach Anspruch 1 oder 2, worin die erste und zweite Festwiderstandseinrichtung (74, 86) jeweils einen Chip-Widerstand aufweist, der einen vorherbestimmten Widerstand hat, und worin ferner die wahlweisen Verbindungseinrichtungen folgendes aufweisen:

eine erste Pin-Diode (82), die mit dem ersten Chip-Widerstand (78) in Reihe geschaltet ist;

eine zweite Pin-Diode (82), die mit dem zweiten Chip-Widerstand (78) in Reihe geschaltet ist;

und Vorspanneinrichtungen (84) zum wahlweisen Vorspannen der ersten und zweiten Pin-Dioden (82) in Sperrichtung, um die erste und zweite Widerstandseinrichtung (77, 86) rasch von der ersten und zweiten Länge der Übertragungsleitung (90, 92) abzuschalten und zum wahlweisen Vorspannen der ersten und zweiten Pin-Diode (82) in Durchlaßrichtung, um die erste und zweite Widerstandseinrichtung (78, 86) rasch mit der ersten und zweiten Länge der Übertragungsleitung (90, 92) zu verbinden.

4. Vorrichtung nach Anspruch 1, 2 oder 3, worin die Rekombinationseinrichtung (88) eine 90°-Kopplungseinrichtung aufweist, die einen ersten, auf das erste Signal ansprechenden Eingangsanschluß (94) hat, einen zweiten, auf das zweite Signal ansprechenden Eingangsanschluß (96) und einen Ausgangsanschluß (97) sowie einen Abschlußanschluß (102), worin der erste Eingangsanschluß (94) mit dem Ausgangsanschluß (97) elektrisch verbunden und mit dem Abschlußanschluß (102) elektromagnetisch gekoppelt ist, und worin ferner der zweite Eingangsanschluß (96) mit dem Ausgangsanschluß (97) elektromagnetisch gekoppelt und mit dem Abschlußanschluß (102) elektrisch verbunden ist, so daß die ersten und zweiten Signale innerhalb der Rekombinationseinrichtung (88) zur Ausgabe aus dem Ausgangsanschluß (97) kombiniert werden.

5. Vorrichtung nach einem der Ansprüche 1 bis 4, worin die ersten Festwiderstandseinrichtungen (77, 86) eine erste Vielzahl konzentrierter Widerstandselemente (78) einschließen, von denen jedes wahlweise in Nebenschluß mit der ersten Länge der Übertragungsleitung (90) schaltbar ist; und worin ferner die zweiten Festwiderstandseinrichtungen (77, 86) eine zweite Vielzahl konzentrierter Widerstand-(78)-Elemente einschließen, von denen jedes wahlweise in Nebenschluß mit der zweiten Länge der Übertragungsleitung (92) schaltbar ist; wobei jedes der ersten Vielzahl konzentrierter Widerstandselemente (78) im wesentlichen die gleichen Widerstandswerte hat wie entsprechende der zweiten Vielzahl konzentrierter Widerstandselemente (78), so daß durch Wahl korrespondierender Widerstandselemente (78) aus der ersten und zweiten Vielzahl von Widerstandselementen (78) eine Impedanzfehlanpassung erzeugt werden kann, die eine wählbare Größe hat.

6. Vorrichtung nach Anspruch 3, worin die Vorspanneinrichtungen (84) eine erste Treibereinrichtung zum Treiben der ersten Pin-Diode (82) und eine zweite Treibereinrichtung zum Treiben der zweiten Pin-Diode (82) aufweisen; wobei jede Treibereinrichtung eine anfängliche hohe Stromspitze und eine anschließende stationäre Vorspannung liefert, so daß die Pin-Dioden (82) mit einem Minimum an Verzögerung zwischen Ein- und Aus-Zuständen geschaltet werden können.

7. Verfahren für das Dämpfen eines hochfrequenten, elektromagnetischen Eingangssignals hoher Leistung, welches die folgenden Schritte aufweist:

Aufteilen des Eingangssignals in ein erstes geteiltes Signal und ein zweites geteiltes Signal mittels einer ersten Kopplungseinrichtung, worin das erste geteilte Signal gegenüber dem zweiten geteilten Signal um ein vorherbestimmtes Ausmaß phasenverschoben ist und beide geteilten Signale im wesentlichen gleiche Leistungsgrößen haben, deren Summe im wesentlichen der Eingangssignalleistungsgröße gleicht;

Anlegen des ersten und zweiten geteilten Signals an eine variable Impedanzfehlanpassung, so daß ein Teil des ersten und zweiten geteilten Signals reflektiert und ein Teil an eine zweite Kopplungseinrichtung übertragen wird, wobei die erste Übertragungseinrichtung dann die reflektierten Signalteile intern vernichtet; und

Rekombinieren des übertragenen Teils des geteilten Signals in einer zweiten Kopplungseinrichtung durch Phasenverschiebung eines der geteilten Signale, so daß es im wesentlichen mit dem anderen geteilten Signal in Phase ist, und Zusammenaddieren der resultierenden Signale, wobei die variable Impedanzfehlanpassung so gewählt wird, daß die Summe der Leistungsgrößen der übertragenen Teile der geteilten Signale der Eingangssignalleistungsgröße gedämpft um ein gewünschtes Ausmaß entspricht,

dadurch gekennzeichnet, daß zum Dämpfen des Eingangssignals in wählbaren Stufen das erste und zweite geteilte Signal an eine wählbare Impedanzfehlanpassung angelegt wird, die Festwiderstandseinrichtungen aufweist.

## Revendications

1. Appareil pour atténuer un signal d'entrée électromagnétique à haute fréquence ayant une amplitude de puissance prédéterminée, comprenant

des moyens (64) qui, en réponse au signal d'entrée, divisent le signal d'entrée en un premier signal et en un second signal ayant chacun une amplitude prédéterminée, la somme des amplitudes étant sensiblement égale à l'amplitude du signal d'entrée, les moyens de division du signal d'entrée ayant un premier accès de sortie (44) destiné à délivrer le premier signal et un second accès de sortie (46) destiné à délivrer le second signal, l'accès d'entrée (40) étant isolé des premier et second accès de sortie (44, 46) par le fait que des formes d'ondes réfléchies des premier et second accès de sortie (44, 46) et renvoyées dans les moyens (64) de division du signal d'entrée s'annulent mutuellement à l'accès d'entrée (40) et s'additionnent l'une à l'autre à un accès de terminaison (59) pour une dissipation dans une terminaison (76);

des moyens de désadaptation en communication avec les premier et second accès de sortie (44, 46) pour produire une désadaptation ajustable d'impédance à chaque accès de sortie (44, 46) afin qu'une partie du premier signal provenant du premier accès de sortie (44) et une partie du second signal provenant du second accès de sortie (46) soient renvoyées par réflexion dans les moyens (64) de division du signal d'entrée pour y être dissipées, et que la partie non réfléchie de chacun des premier et second signaux soit transmise, lesdits moyens de désadaptation comprenant:

une première longueur d'une ligne (90) de transmission à guide d'onde à ruban connectant électriquement le premier accès de sortie (44) à un moyen (88) de recombinaison;

une seconde longueur de ligne (92) de transmission à guide d'onde à ruban connectant électriquement le second accès de sortie au moyen (88) de recombinaison et des moyens de désadaptation destinés à régler le degré de désadaptation d'impédance, lesdits moyens de désadaptation comprenant des premier et second moyens à résistances (77, 86) qui produisent ledit degré de désadaptation d'impédance et qui sont agencés en parallèle avec les première et seconde longueurs de ligne de transmission (90, 92) respectivement, caractérisé en ce que lesdits premier et second moyens à résistances sont des moyens à résistances fixes (77, 86) qui peuvent être connectés sélectivement en parallèle avec la longueur respective de ligne de transmission (90, 92); et

des moyens de connexion (82) sont prévus pour ladite connexion pouvant être choisie des premier et second moyens à résistances fixes (77, 86) sur les première et seconde longueurs de ligne de transmission (90, 92).

2. Appareil selon la revendication 1, caractérisé en ce que les moyens (64) de division du signal d'entrée comprennent

une première ligne de transmission en bande quart d'onde (68) ayant une première extrémité connectée électriquement à l'accès d'entrée (40) et son autre extrémité connectée électriquement au premier accès de sortie (44);

une seconde ligne de transmission en bande quart d'onde (72) ayant une première extrémité connectée électriquement à l'accès (59) terminal de dissipation et son autre extrémité connectée électriquement au second accès de sortie (46);

la seconde ligne de transmission (72) étant placée dans un plan hypothétique qui est espacé du plan de la première ligne de transmission (68), mais lui est parallèle, afin que le signal d'entrée soit couplé électromagnétiquement du premier accès (40) d'entrée au second accès (46) de sortie sans déphasage et avec une amplitude de puissance qui est inférieure de 3 dB à l'amplitude de puissance du signal d'entrée, et afin que le signal d'entrée soit couplé électriquement au premier accès de sortie (44) avec un déphasage de 90° et une amplitude inférieure de 3 dB à l'amplitude du signal d'entrée; et

en outre, une première forme d'onde réfléchie, ayant une amplitude de puissance et une phase, qui est insérée dans le premier accès de sortie (44), est annulée à l'accès d'entrée (40) par, et dissipée à l'accès de terminaison (59) conjointement avec, une seconde forme d'onde réfléchie ayant la même amplitude de puissance que la première forme d'onde et déphasée de 90° par rapport à la première forme d'onde et qui est insérée dans le second accès de sortie (46).

3. Appareil selon la revendication 1 ou 2, dans lequel les premier et second moyens à résistances fixes (74, 86) comprennent chacun une résistance à puce ayant une valeur prédéterminée, et dans lequel en outre les moyens de connexion sélectifs comprennent

une première diode "pin" (82) connectée en série avec la première résistance à puce (78);

une seconde diode "pin" (82) connectée en série avec la seconde résistance à puce (78);

et des moyens de polarisation (84) destinés à polariser sélectivement en inverse les première et seconde diodes pin (82) pour déconnecter rapidement les premier et second moyens à résistances (77, 86) des première et seconde longueurs de ligne de transmission (90, 92), et à polariser sélectivement dans le sens passant les première et seconde diodes pin (82) pour connecter rapidement les premier et second moyens à résistances (78, 86) sur les première et seconde longueurs de ligne de transmission (90, 92).

4. Appareil selon la revendication 1, 2 ou 3, dans lequel les moyens de recombinaison (88) comprennent un coupleur de quadrature ayant un premier accès d'entrée (94) sensible au premier signal, un second accès d'entrée (96) sensible au second signal, un accès de sortie (97) et un accès de terminaison (102), le premier accès d'entrée (94) étant connecté électriquement à l'accès de sortie (97) et couplé électromagnétiquement à l'accès de terminaison (102), et le second accès d'entrée (96) étant couplé électromagnétiquement à l'accès de sortie (97) et connecté électriquement à l'accès de terminaison (102), afin que les premier et second signaux soient combinés dans le moyen (88) de recombinaison pour être délivrés à partir de l'accès (97) de sortie.

5. Appareil selon l'une quelconque des revendications 1 à 4, dans lequel les premiers moyens à résistances fixes (77, 86) comprennent un premier groupe d'éléments résistants localisés (78) pouvant, chacun être connectés sélectivement en shunt avec la première longueur de ligne de transmission (90); et dans lequel en outre les seconds moyens à résistances fixes (77, 86) comprennent un second groupe d'éléments résistants localisés (78) pouvant chacun être connectés sélectivement en shunt avec la seconde longueur de ligne de transmission (92); chacun des éléments résistants localisés (78) du premier groupe ayant sensiblement la même valeur de résistance que l'un, correspondant, des éléments résistants localisés (78) du second groupe afin qu'en sélectionnant des éléments résistants correspondants (78) des premier et second groupes d'éléments résistants (78), on puisse créer une désadaptation d'impédance d'une amplitude pouvant être choisie.

6. Appareil selon la revendication 3, dans lequel les moyens de polarisation (84) comprennent un premier moyen d'impact destiné à attaquer la première diode pin (82) et un second moyen d'attaque destiné à attaquer la seconde diode pin (82); chaque moyen d'attaque produisant un pic de courant élevé initial et ensuite une tension de polarisation en régime stabilisé afin que les diodes pin (82) puissent être commutées entre des états hors et en avec un retard minimal.

7. Procédé pour atténuer un signal d'entrée électromagnétique à haute puissance, haute fréquence, comprenant les étapes suivantes qui consistent:

à diviser le signal d'entrée en un premier signal divisé et en un second signal divisé à l'aide d'un premier moyen coupleur dans lequel le premier signal divisé est déphasé par rapport au second signal divisé d'une valeur prédéterminée et les deux signaux divisés ont sensiblement des amplitudes de puissance égales, dont le total est sensiblement égal à l'amplitude de puissance du signal d'entrée;

à appliquer les premier et second signaux divisés à une désadaptation variable d'impédance afin qu'une partie des premier et second signaux divisés soit réfléchie et qu'une partie soit transmise à un second moyen coupleur, le premier moyen coupleur dissipant alors de façon interne les parties de signaux réfléchies; et

à recombiner la partie transmise du signal divisé dans un second moyen coupleur en déphasant l'un des signaux divisés afin qu'il soit sensiblement égal en phase avec l'autre signal divisé et en additionnant l'un à l'autre les signaux résultants, ladite désadaptation d'impédance variable étant choisie de manière que la somme des amplitudes de puissance des parties transmises des signaux divisés corresponde à l'amplitude de puissance du signal d'entrée qui a été atténuée d'une valeur souhaitée;

caractérisé en ce que, pour atténuer ledit signal d'entrée dans des étapes pouvant être choisies, lesdits premier et second signaux divisés sont appliqués à un moyen sélectif de désadaptation d'impédance comprenant des moyens résistifs fixes.

EP 0 101 941 B1

(PRIOR ART)

FIG.1.

(PRIOR ART)

FIG.2.

1

FIG.3.

FIG.5A.

FIG.5.

FIG.5B.

EP 0 101 941 B1

FIG 4